# EUROPEAN PATENT APPLICATION

(11) **EP 4 739 007 A1**
(43) Date of publication of application: **06.05.2026**
(21) Application number: 24831995.6
(22) Date of filing: 26.06.2024
(51) Int. Cl.: H05K 3/26, B23K 35/26, B23K 35/363, C11D 7/26, C11D 7/32, C22C 13/00

(54) **CLEANING AGENT COMPOSITION FOR REMOVING FLUX RESIDUE**

(30) Priority: 28.06.2023 JP 2023106301
(71) Applicant: Kao Corporation, Tokyo 103-8210 (JP)
(72) Inventor: SEIKE, Takanao, Tokyo 103-8210 (JP)
(74) Representative: Hoffmann Eitle
(86) International application number: PCT/JP2024/023174
(87) International publication number: WO 2025/005136

(57) **Abstract**

In one aspect, provided is a cleaning agent composition for removing flux residue that has excellent flux residue removal performance while suppressing metal corrosion and suppressing damage to an organic coating film.

In one aspect, the present disclosure relates to a cleaning agent composition for removing flux residue that contains a compound (a component A) represented by a formula (I) below, a benzotriazole derivative (a component B), and an imidazole derivative or a pyrazole derivative (a component C).

R¹-O-(AO)ₙ-R² (I)

In the above formula (I), R¹ represents a phenyl group or an alkyl group having 1 to 8 carbon atoms, R² represents a hydrogen atom or an alkyl group having 1 to 4 carbon atoms, AO represents an ethylene oxide group (EO) or a propylene oxide group (PO), and n is the number of moles of AO added and is an integer of 1 to 3.

## Description

### Technical Field

The present disclosure relates to a cleaning agent composition for removing flux residue, a cleaning method using the cleaning agent composition, and a method for manufacturing an electronic component.

### Background Art

In order to reduce manufacturing costs, metals such as copper and copper alloys are used for electrodes forming circuits on electronic substrates of semiconductor packages or the like.

Surface mounting with improved packing density is widely used as a mounting method for printed wiring boards. In order to improve the packing density, a technique is known in which a nanometal paste is applied between the wiring on a substrate and the terminals of an electronic element, and the nanometal is melted and solidified through heating to bond the wiring on the substrate and the terminals of the electronic element.

For example, JP 2020-35721A (Patent Document 1) discloses a semiconductor element that adheres to and is fixed on a substrate via a die attach material made of a paste composition containing specific silver minute particles, specific silver powder, and a silicon-containing triazine compound, and further contains, as a sintering aid, a carboxylic acid compound, which is an acid anhydride having a boiling point of 100°C to 300°C. Paragraph 0051 of the same document discloses that it is not preferable that the boiling point of the carboxylic acid compound exceeds 300°C because the compound will not volatilize during sintering and flux components (organic substances such as organic acids) will remain in the film.

Meanwhile, a technique for cleaning off solder flux from electronic components after soldering is known.

For example, WO 2020/116534 (Patent Document 2) proposes a cleaning method for cleaning an object to be cleaned having flux residue, using a cleaning agent composition containing an organic solvent and a compound having an alkyl group having 1 to 4 carbon atoms on the nitrogen atom of an imidazole ring or a piperazine ring.

WO 2019/044463 (Patent Document 3) proposes a treatment liquid for a semiconductor device that contains water, an organic solvent, and two or more nitrogen-containing aromatic heterocyclic compounds.

JP 2005-41989A (Patent Document 4) proposes a cleaning agent composition for a tin-containing alloy component that contains, as active ingredients, an organic carboxylate, a nitrogen-based heterocyclic compound, and an organic solvent.

### Disclosure of Invention

In one aspect, the present disclosure relates to a cleaning agent composition for removing flux residue, containing: a compound (a component A) represented by a formula (I) below; a benzotriazole derivative (a component B); and an imidazole derivative or a pyrazole derivative (a component C),

R¹-O-(AO)ₙ-R² (I)

in the above formula (I), R¹ represents a phenyl group or an alkyl group having 1 to 8 carbon atoms, R² represents a hydrogen atom or an alkyl group having 1 to 4 carbon atoms, AO represents an ethylene oxide group (EO) or a propylene oxide group (PO), and n is the number of moles of AO added and is an integer of 1 to 3.

In one aspect, the present disclosure relates to a cleaning method including a cleaning step of cleaning an object to be cleaned having flux residue, using the cleaning agent composition according to the present disclosure.

### Description of the Invention

When applying a nonmetal paste containing an acid (flux component), melting and solidifying the nanometal through heating to connect the wiring present on a substrate to the terminals of electronic elements, a process of keeping the substrate at a high temperature of 200°C or higher to melt the metal (sintering process) is required. If flux residue containing the acid as a main component remains on the substrate that has undergone the sintering process, the substrate needs to be cleaned. Thus, there is demand for a cleaning agent composition having high cleaning performance against the flux residue (flux residue removal performance).

Further, in some cases, an organic coating film (surface protecting film) is formed on a substrate surface or a surface of a metal member using a water-soluble preflux. When sintering and flux removal are performed on a portion of the same substrate surface, or when metal members are present on both sides of the same substrate, the cleaning agent composition may come into contact with the organic coating film. In order to suppress removal of the organic coating film while the flux residue is cleaned off, there is demand for a cleaning agent composition with little damage to an organic coating film.

Furthermore, because corrosion of a metal used in the substrate surface or a metal component reduces the quality and value of package substrates, there is demand for a cleaning agent composition having a high metal corrosion prevention ability (anti-corrosion property).

In view of this, the present disclosure provides a cleaning agent composition for removing flux residue that has excellent flux residue removal performance while suppressing metal corrosion and damage to an organic coating film, and a cleaning method.

According to the present disclosure, it is possible to provide a cleaning agent composition for removing flux residue that has excellent flux residue removal performance while suppressing metal corrosion and damage to an organic coating film, and a cleaning method.

The present invention is based on findings that, by using a compound (a component A) represented by the above formula (I), a benzotriazole derivative (a component B), and an imidazole derivative or a pyrazole derivative (a component C) in combination, flux residue can be efficiently removed while suppressing metal corrosion and damage to an organic coating film.

In one aspect, the present disclosure relates to a cleaning agent composition for removing flux residue (also referred to as "a cleaning agent composition according to the present disclosure" hereinafter) that contains the compound (the component A) represented by the above formula (I), the benzotriazole derivative (the component B), and the imidazole derivative or the pyrazole derivative (the component C).

Although details of the mechanism of the expression of the effects of the present disclosure are unclear, the following is inferred.

The component B (benzotriazole derivative) and the component C (imidazole derivative or pyrazole derivative), which are nitrogen-containing aromatic heterocyclic compounds, can coordinate to a metal via a nitrogen atom. It is conceivable that copper ions are formed by the dissolution of an organic coating film by the component A (the compound represented by a formula (I)), and the resulting copper ions react with the component B and the component C to reform the organic coating film. In this case, it is presumed that, compared to the case where each of the component B and the component C are present alone, the presence of both the component B and the component C makes it possible to form a dense organic coating film with a significantly superior anti-corrosion property. As a result, it is conceivable that the organic coating film has excellent flux residue removal performance while suppressing metal corrosion and damage to the organic coating film.

However, the present disclosure need not be interpreted as being limited to this mechanism.

The term "flux" used in this disclosure refers to, in one or more embodiments, flux used to join two members by a sintering process (for example, a process in which the temperature is maintained at 200°C or higher), and is used to, for example, join a heat sink and a semiconductor element together or join a heat sink and a substrate together. Flux is a joining aid containing acid as a main component in one or more embodiments.

The term "cleaning agent composition for removing flux residue" used in this disclosure refers to, in one or more embodiments, a cleaning agent composition for removing flux residue remaining after joining two members together by the sintering process.

### [Component A: Compound Represented by Formula (I)]

The cleaning agent composition in this disclosure includes a compound represented by the formula (I) below (hereinafter also referred to as "component A"). The component A may be one type or a combination of two or more.

R¹-O-(AO)ₙ-R² (I)

In the above formula (I), R¹ represents a phenyl group or an alkyl group having 1 to 8 carbon atoms, R² represents a hydrogen atom or an alkyl group having 1 to 4 carbon atoms, AO represents an ethylene oxide group (EO) or a propylene oxide group (PO), and n is the number of moles of AO added and is an integer of 1 to 3.

In the above formula (I), from the viewpoint of improving flux residue removal performance, R¹ is preferably an alkyl group having 1 to 8 carbon atoms, and more preferably an alkyl group having 4 to 6 carbon atoms. From a similar point of view, R² is preferably a hydrogen atom or an alkyl group having 2 to 4 carbon atoms, and more preferably a hydrogen atom. From a similar point of view, AO is preferably an ethylene oxide group (EO). From a similar point of view, n is preferably 2 or 3, and more preferably 2.

Examples of the component A include monophenyl ethers such as ethylene glycol monophenyl ether, diethylene glycol monophenyl ether, and triethylene glycol monophenyl ether; monoalkyl ethers such as an ethylene glycol monoalkyl ether, a diethylene glycol monoalkyl ether, a triethylene glycol monoalkyl ether, and a tripropylene glycol monoalkyl ether, each of which having an alkyl group having 1 to 8 carbon atoms; dialkyl ethers such as ethylene glycol dialkyl ether, diethylene glycol dialkyl ether, and triethylene glycol dialkyl ether, each of which having an alkyl group having 1 to 8 carbon atoms and an alkyl group having 1 to 4 carbon atoms; phenyl alkyl ethers such as ethylene glycol phenyl alkyl ethers, diethylene glycol phenyl alkyl ethers, and triethylene glycol phenyl alkyl ethers, each of which having a phenyl group and an alkyl group having 1 to 4 carbon atoms.

Among these, from the viewpoints of improving flux residue removal performance, suppressing metal corrosion, and suppressing damage to an organic coating film, the component A is preferably at least one selected from diethylene glycol monoalkyl ether and dipropylene glycol monoalkyl ether, and for example, the component A is at least one selected from diethylene glycol monobutyl ether (butyl diglycol, BDG), dipropylene glycol monobutyl ether (BFDG), and diethylene glycol monohexyl ether (hexyldiglycol).

From the viewpoint of improving flux residue removal performance, the content of the component A during use of the cleaning agent composition according to this disclosure is preferably 35% by mass or more, more preferably 50% by mass or more, and even more preferably 75% by mass or more, and from the viewpoint of suppressing metal corrosion and damage to the organic coating film, is preferably 99.5% by mass or less, more preferably 95% by mass or less, and even more preferably 90% by mass or less. More specifically, from the viewpoint of improving flux residue removal performance, suppressing metal corrosion, and suppressing damage to an organic coating film, the content of the component A during use of the cleaning agent composition according to this disclosure is preferably 35% by mass or more and 99.5% by mass or less, more preferably 50% by mass or more and 95% by mass or less, and even more preferably 75% by mass or more and 90% by mass or less. When the component A is a combination of two or more types, the content of the component A refers to a total content thereof.

### [Component B: Benzotriazole Derivative]

The cleaning agent composition according to this disclosure includes a benzotriazole derivative (hereinafter also referred to as "component B"). Examples of the component B include a compound represented by a formula (II) below or a compound represented by a formula (III) below, and a compound represented by the formula (III) is preferable from the viewpoint of improving flux residue removal performance, suppressing metal corrosion, and suppressing damage to an organic coating film. The component B may be one type or a combination of two or more.

### <Compound Represented by Formula (II)>

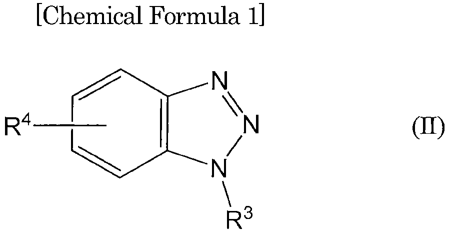

In the above formula (II), R³ and R⁴ each independently represent a hydrogen atom, a halogen atom, a hydroxy group, an alkyl group having 1 to 8 carbon atoms, a carboxy group, an amino group, or a nitro group.

In the above formula (II), R³ is preferably a hydrogen atom from the viewpoint of suppressing metal corrosion and suppressing damage to an organic coating film. From a similar point of view, R⁴ is preferably a hydrogen atom or an alkyl group having 1 to 8 carbon atoms, more preferably a hydrogen atom or a methyl group, and even more preferably a hydrogen atom.

Examples of the compounds represented by the above formula (II) include benzotriazole, 5-methylbenzotriazole, 4-methylbenzotriazole, and triazole (a mixture of 4-methylbenzotriazole and 5-methylbenzotriazole).

### <Compound Represented by Formula (III)>

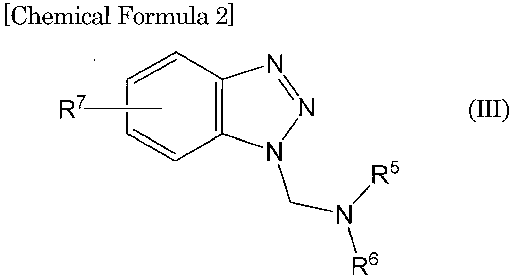

In the above formula (III), R⁵ and R⁶ each independently represent an alkyl group having 1 to 8 carbon atoms, and R⁷ represents a hydrogen atom or a methyl group.

In the above formula (III), from the viewpoint of suppressing metal corrosion and suppressing damage to an organic coating film, R⁵ and R⁶ are each preferably an alkyl group having 6 to 8 carbon atoms, and more preferably an alkyl group having 8 carbon atoms. From a similar point of view, R⁷ is preferably a hydrogen atom.

Examples of the compounds represented by the above formula (III) include 1-[N,N-bis(2-ethylhexyl)aminomethyl]benzotriazole (BT-LX) and 1-[N,N-bis(2-ethylhexyl)aminomethyl]methylbenzotriazole (TT-LX).

From the viewpoint of suppressing metal corrosion and suppressing damage to an organic coating film, the content of the component B during use of the cleaning agent composition according to this disclosure is preferably 0.05% by mass or more, more preferably 0.1% by mass or more, and even more preferably 0.3% by mass or more, and from the viewpoint of solubility in the component A, the content of the component B is preferably 5% by mass or less, more preferably 3% by mass or less, and even more preferably 1% by mass or less. More specifically, the content of the component B during use of the cleaning agent composition according to this disclosure is preferably 0.05% by mass or more and 5% by mass or less, more preferably 0.1% by mass or more and 3% by mass or less, and even more preferably 0.3% by mass or more and 1% by mass or less. When the component B is a combination of two or more types, the content of the component B refers to a total content thereof.

From the viewpoint of improving flux residue removal performance and solubility in the component A, a mass ratio A/B of the component A to the component B (the content of the component A/the content of the component B) in the cleaning agent composition according to this disclosure is preferably 50 or more, preferably 100 or more, preferably 150 or more, and may be 200 or more. In addition, from the viewpoint of suppressing metal corrosion and suppressing damage to an organic coating film, the mass ratio A/B is preferably 1000 or less, preferably 500 or less, preferably 300 or less, and may be 250 or less. More specifically, the mass ratio A/B is preferably 50 or more and 1000 or less, more preferably 100 or more and 500 or less, and even more preferably 150 or more and 300 or less.

### [Component C: Imidazole Derivative or Pyrazole Derivative]

The cleaning agent composition according to this disclosure contains an imidazole derivative or a pyrazole derivative (hereinafter also referred to as "component C"). The component C may be one type or a combination of two or more.

### <Imidazole Derivative>

Examples of the imidazole derivative include compounds represented by a formula (IV) below.

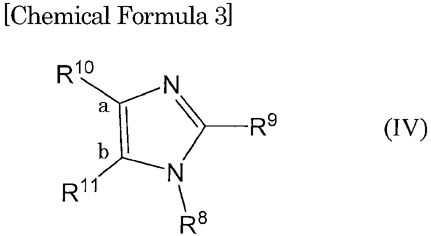

In the above formula (IV), R⁸, R⁹, R¹⁰ and R¹¹ each independently represent a hydrogen atom, a hydroxy group, an alkyl group having 1 to 8 carbon atoms, or a phenyl group, and R¹⁰ and R¹¹ may form a benzene ring together with carbon atoms at a and b.

In the above formula (IV), from the viewpoint of improving flux residue removal performance, suppressing metal corrosion, and suppressing damage to an organic coating film, R⁸, R⁹, R¹⁰, and R¹¹ each independently preferably represent a hydrogen atom or an alkyl group having 1 to 8 carbon atoms, and more preferably a hydrogen atom or a methyl group.

From the viewpoint of improving flux residue removal performance, suppressing metal corrosion, and suppressing damage to an organic coating film, the compound represented by the formula (IV) is at least one selected from imidazole, 1-methylimidazole, 1-ethylimidazole, 1-propylimidazole, 1-isopropylimidazole, 1-acetylimidazole, 1-aminopropylimidazole, 1-hydroxyethylimidazole, 2-methylimidazole, 2-ethylimidazole, 2-propylimidazole, 2-isopropylimidazole, 2-acetylimidazole, 2-aminopropylimidazole, 2-hydroxyethylimidazole, 4-methylimidazole, 4-ethylimidazole, 4-propylimidazole, 4-isopropylimidazole, 4-acetylimidazole, 4-aminopropylimidazole, 4-hydroxyethylimidazole, 1,2-dimethylimidazole, 1-isobutyl-2-methylimidazole, 2-ethyl-4-methylimidazole, and benzimidazole.

Among these compounds, from the viewpoint of improving flux residue removal performance, suppressing metal corrosion, and suppressing damage to an organic coating film, the compound represented by the formula (IV) is preferably at least one selected from imidazole, 1-methylimidazole, 2-methylimidazole, and benzimidazole, and more preferably imidazole and 2-methylimidazole, and even more preferably 2-methylimidazole.

### <Pyrazole Derivative>

Examples of the pyrazole derivative include compounds represented by a formula (V) below.

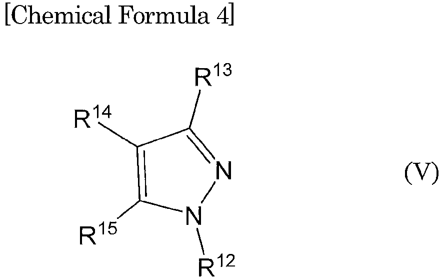

In the above formula (V), R¹², R¹³, R¹⁴ and R¹⁵ each independently represent a hydrogen atom, a hydroxy group, an alkyl group having 1 to 8 carbon atoms, or a phenyl group, and R¹⁴ and R¹⁵ may be bonded together to form a ring.

In the above formula (V), R¹², R¹³, R¹⁴ and R¹⁵ are each preferably a hydrogen atom from the viewpoint of improving flux residue removal performance, suppressing metal corrosion, and suppressing damage to an organic coating film.

Examples of the compounds represented by the formula (V) include pyrazole and 3,5-dimethylpyrazole.

From the viewpoint of suppressing metal corrosion and suppressing damage to an organic coating film, the content of the component C during use of the cleaning agent composition according to this disclosure is preferably 0.05% by mass or more, more preferably 0.1% by mass or more, and even more preferably 0.3% by mass or more, and from the viewpoint of solubility in the component A, the content of the component C is preferably 5% by mass or less, more preferably 3% by mass or less, and even more preferably 1% by mass or less. More specifically, the content of the component C during use of the cleaning agent composition according to this disclosure is preferably 0.05% by mass or more and 5% by mass or less, more preferably 0.1% by mass or more and 3% by mass or less, and even more preferably 0.3% by mass or more and 1% by mass or less. When the component C is a combination of two or more types, the content of the component C refers to a total content thereof.

From the viewpoint of suppressing metal corrosion and suppressing damage to an organic coating film, a mass ratio B/C of the component B to the component C (the content of the component B/the content of the component C) in the cleaning agent composition according to this disclosure is preferably 0.01 or more, more preferably 0.1 or more, and even more preferably 0.5 or more, and from a similar viewpoint, the mass ratio B/C is preferably 100 or less, more preferably 10 or less, and even more preferably 5 or less. More specifically, the mass ratio B/C is preferably 0.01 or more and 100 or less, more preferably 0.1 or more and 10 or less, and even more preferably 0.5 or more and 5 or less.

From the viewpoint of improving flux residue removal performance and solubility in the component A, a mass ratio A/C of the component A to the component C (the content of the component A/the content of the component C) in the cleaning agent composition according to this disclosure is preferably 20 or more, preferably 50 or more, preferably 70 or more, and from the viewpoint of metal corrosion and damage to an organic coating film, the mass ratio A/C is preferably 500 or less, preferably 300 or less, and preferably 200 or less. More specifically, the mass ratio A/C is preferably 20 or more and 500 or less, more preferably 50 or more and 300 or less, and even more preferably 70 or more and 200 or less.

From the viewpoint of improving flux residue removal performance, a total content of the component A, the component B, and the component C in the cleaning agent composition according to this disclosure is preferably 50% by mass or more, preferably 70% by mass or more, preferably 80% by mass or more, and preferably 85% by mass or more. From the viewpoint of reducing the flash point, the total content of the component A, the component B, and the component C is preferably 100% by mass or less, preferably 95% by mass or less, and preferably 90% by mass or less. More specifically, the total content of the component A, the component B, and the component C is preferably 50% by mass or more and 100% by mass or less, more preferably 70% by mass or more and 95% by mass or less, even more preferably 80% by mass or more and 90% by mass or less, and further preferably 85% by mass or more and 90% by mass or less.

### [Component D: Water]

The cleaning agent composition according to this disclosure may further contain water (hereinafter also referred to as "component D") in one or more embodiments. Examples of the component D include ion-exchanged water, RO water (reverse osmosis treated water), distilled water, pure water, and ultrapure water.

When the cleaning agent composition according to this disclosure contains the component D, from the viewpoint of reducing the flash point, the content of the component D during use of the cleaning agent composition according to this disclosure is preferably 1% by mass or more, more preferably 5% by mass or more, and even more preferably 8% by mass or more, and from the viewpoint of improving flux residue removal performance, the content of the component D is preferably 15% by mass or less, more preferably 14% by mass or less, and even more preferably 13% by mass or less. More specifically, the content of the component D in the cleaning agent composition according to this disclosure is preferably 1% by mass or more and 15% by mass or less, more preferably 5% by mass or more and 14% by mass or less, and even more preferably 8% by mass or more and 13% by mass or less.

### [Other Components]

The cleaning agent composition according to this disclosure may contain, as appropriate, in a range in which effects of this disclosure are not impaired, a chelating agent such as 1-hydroxyethylidene-1,1-diphosphonic acid (HEDP), a rust-preventive agent, a thickening agent, a dispersing agent, a solvent other than the component A, a basic substance (e.g., dibutylaminoethanol, diisopropanolamine, or the like), a pH adjusting agent, a polymer compound, a surfactant, a solubilizer, an antiseptic, a disinfectant, an antibacterial agent, an antifoaming agent, an antioxidant, and an organic carboxylate (e.g., tin(II) 2-ethylhexanoate or the like).

The content of the other components in the cleaning agent composition according to this disclosure is preferably 0% by mass or more and 10% by mass or less, more preferably 0% by mass or more and 8% by mass or less, and even more preferably 0% by mass or more and 6% by mass or less.

### [Method for Manufacturing Cleaning Agent Composition]

The cleaning agent composition according to this disclosure can be manufactured by blending together, for example, the component A, the component B, the component C, and, if necessary, optional components (the component D and other components), using a well-known method. In one or more embodiments, the cleaning agent composition according to this disclosure may be obtained by blending at least the component A, the component B, and the component C together. Therefore, in one aspect, this disclosure relates to a method for manufacturing a cleaning agent composition including a step of blending at least the component A, the component B, and the component C together. The term "blending" used in this disclosure includes mixing the component A, the component B, the component C, and, if necessary, optional components (the component D and other components) simultaneously or in any order.

In the method for manufacturing a cleaning agent composition according to this disclosure, the blend amount of each component may be the same as the content of the component at the time of use of the cleaning agent composition according to this disclosure described above.

The wording "content of each component at the time of use of the cleaning agent composition" refers to the content of the component at the time of cleaning, i.e., at the time when use of the cleaning agent composition for cleaning is started.

In one or more embodiments, the cleaning agent composition according to this disclosure is used to clean an object to be cleaned having flux residue, in particular, an object to be cleaned having flux residue remaining after two members are joined together through a sintering process.

In one or more embodiments, the cleaning agent composition according to this disclosure may be used as a cleaning agent to remove flux residue from an object to be cleaned having the flux residue. Therefore, in one aspect, this disclosure relates to use of the cleaning agent composition containing the component A, the component B, and the component C (i.e., the cleaning agent composition according to this disclosure) as a flux residue cleaning agent.

In one or more other embodiments, the cleaning agent composition according to this disclosure can be used as a removing agent for removing flux residue from an object to be cleaned having the flux residue. Accordingly, in other respects, this disclosure relates to a flux residue removal cleaning agent composition comprising the cleaning agent composition according to this disclosure (hereinafter also referred to as "flux residue removal cleaning agent composition according to this disclosure"). In another aspect, this disclosure relates to use of the cleaning agent composition according to this disclosure or the flux residue removal cleaning agent composition according to this disclosure as a flux residue removing agent.

### [Object to be Cleaned]

In one or more embodiments, the object to be cleaned may be, e.g., a substrate having flux residue that has undergone the process of heating to 200°C or higher. In one or more embodiments, the object to be cleaned may be, e.g., a substrate having a metal member containing copper formed thereon and flux residue, which has undergone the process of heating to 200°C or higher. The process of heating to 200°C or higher is the process of maintaining a high temperature of 200°C or higher (sintering process) in one or more embodiments.

In one or more embodiments, examples of objects to be cleaned include objects to be cleaned having flux residue. In one or more embodiments, examples of the object to be cleaned having flux residue include a substrate having flux residue that has undergone a process of applying a slurry containing a flux between the substrate and a metal member or between two metal members on the substrate, and then heating to 200°C or higher (sintering process). Therefore, in one aspect, this disclosure relates to use of the cleaning agent composition according to this disclosure in the cleaning of the substrate having flux residue that has undergone the process of applying the slurry containing a flux between the substrate and the metal member or between the two metal members on the substrate, and then heating to 200°C or higher (sintering process).

In the sintering process, the heating temperature is, for example, 200°C to 350°C. The heating time is, for example, 3 minutes to 5 hours. From the viewpoint of exhibiting cleaning performance against thermal deterioration of flux, it is preferable that the object to be cleaned is an object to be cleaned that has been heated for 1 hour or longer.

In one or more embodiments, the substrate surface and/or the metal member of the object to be cleaned include a portion where the metal has been discolored by heating, that is, a portion where the metal has been oxidized (metal oxide).

The substrate surface and/or the metal member of the object to be cleaned include an organic coating film containing an imidazole derivative in one or more embodiments. The substrate surface and/or the metal member of the object to be cleaned include an organic coating film that has come into contact with an agent containing an imidazole derivative in one or more embodiments. The organic coating film is a surface protecting film for protecting the substrate surface and/or the metal member in one or more embodiments. The organic coating film is formed through water-soluble preflux (Organic Solderability Preservative (OSP)) treatment in one or more embodiments. Examples of a method for forming an organic coating film include a method for immersing the substrate surface and/or the surface of the metal member in a water-soluble preflux in one or more embodiments. The immersion temperature is, for example, 30°C to 50°C, and the immersion time is, for example, 30 seconds to 90 seconds. The thickness of the organic coating film is, for example, 0.1 µm to 0.3 µm. The water-soluble preflux is an aqueous solution containing an imidazole derivative as a main component in one or more embodiments. The OSP treatment is a Cu-OSP treatment in one or more embodiments.

In one or more embodiments, the object to be cleaned is a substrate having flux residue, which has been subjected to a process of applying a slurry containing a flux between the substrate and a metal member or between two metal members on the substrate, and then heating to 200°C or higher (sintering process), and which includes an organic coating film containing an imidazole derivative.

The flux contains an acid as a main component in one or more embodiments. Examples of the acid include an organic acid such as abietic acid.

The slurry containing the flux may further contain metal particles in one or more embodiments. The metal particles are preferably metal particles having a sintering temperature (curing temperature) of 300°C or lower, and the metal particles are, for example, tin, copper, or silver particles, or particles of their mixed metals. In one or more embodiments, the metal particles serve as a joining material capable of joining together the substrate and the metal members or two metal members on the substrate. The slurry containing the flux can be used as a die attach paste in one or more embodiments. When the slurry containing the flux further contains metal particles, the slurry can be used as a conductive die attach paste in one or more embodiments.

The metal member is fixed onto the substrate in one or more embodiments.

The metal of the metal member includes a metal such as copper or iron in one or more embodiments. Examples of the metal member include a heat sink and an electrical circuit.

In one or more embodiments, the substrate may be a substrate having a metal surface, and examples thereof include a copper plate, a steel plate, a stainless steel plate, a tough pitch copper plate, and a copper-wiring printed circuit board.

The substrate surface and/or the metal member of the object to be cleaned include copper in one or more embodiments.

### [Cleaning Method]

In one aspect, the present disclosure relates to a cleaning method including a cleaning step of cleaning an object to be cleaned having flux residue, using the cleaning agent composition according to the present disclosure (also referred to as the "cleaning method according to the present disclosure" hereinafter). Examples of the object to be cleaned include the aforementioned objects to be cleaned. In one or more embodiments, the cleaning step includes bringing the object to be cleaned having flux residue into contact with the cleaning agent composition according to the present disclosure. With the cleaning method according to the present disclosure, it is possible to efficiently remove flux residue while suppressing metal corrosion and damage to an organic coating film.

Examples of the method for cleaning an object to be cleaned using the cleaning agent composition according to this disclosure, or the method for bringing the cleaning agent composition according to this disclosure into contact with the object to be cleaned includes a method for bringing the object into contact therewith in a chamber of an ultrasonic cleaning device, and a method for bringing the object into contact therewith by spraying the cleaning agent composition (shower method). In one or more embodiments, the cleaning agent composition according to this disclosure can be used for cleaning as-is without dilution.

In one or more embodiments, the cleaning step is a step of immersing the object to be cleaned in the cleaning agent composition according to the present disclosure. From the viewpoint of improving flux residue removal performance, suppressing metal corrosion, and suppressing damage to an organic coating film, the immersion temperature is preferably 80°C or lower, more preferably 70°C or lower, and even more preferably 60°C or lower, and is preferably 20°C or higher, more preferably 30°C or higher, and even more preferably 40°C or higher. For example, in one or more embodiments, the cleaning step is, preferably, a step of immersing the object to be cleaned in the cleaning agent composition according to the present disclosure having a temperature of 80°C or lower. From a similar viewpoint, the immersion time is preferably 5 minutes or longer, more preferably 10 minutes or longer, and even more preferably 30 minutes or longer, and is preferably 3 hours or shorter, more preferably 2 hours or shorter, and even more preferably 1 hour or shorter.

The cleaning method according to this disclosure preferably includes, in one or more embodiments, a step of bringing the object to be cleaned into contact with the cleaning agent composition, rinsing the object to be cleaned with water and/or an alcohol such as methanol, and drying the object to be cleaned.

In the cleaning method according to this disclosure, it is preferable to perform irradiation with ultrasonic waves at the time of contact between the cleaning agent composition according to this disclosure and the object to be cleaned, and it is more preferable that the ultrasonic waves are relatively strong, because the cleaning power of the cleaning agent composition according to this disclosure is easily exhibited. From a similar viewpoint, the frequency of the ultrasonic waves is preferably 26 to 72 kHz and 80 to 1500 W, and more preferably 36 to 72 kHz and 80 to 1500 W.

In one or more other embodiments, the cleaning step in the cleaning method according to this disclosure is a cleaning/removing step of removing flux residue from the object to be cleaned, using a flux residue removing agent (removing step). An example of the flux residue removing agent in the removing step is the flux residue removal cleaning agent composition according to this disclosure.

Specifically, in one or more embodiments, the cleaning method according to this disclosure includes the cleaning/removing step of removing the flux residue from the object to be cleaned using the flux removal cleaning agent composition according to this disclosure, and the object to be cleaned is a substrate that has undergone the step of heating to 200°C or higher (sintering process) and has flux residue.

### [Method for Manufacturing Electronic Component]

In one aspect, this disclosure relates to a method for manufacturing an electronic component using the cleaning method according to this disclosure (also referred to as the "electronic component manufacturing method according to the present disclosure" hereinafter).

In one or more embodiments, the electronic component manufacturing method according to the present disclosure includes a step of applying a flux-containing slurry between a substrate and a metal member or between two metal members present on the substrate, and then heating to 200°C or higher (sintering step), and a step of cleaning the substrate (the object to be cleaned) that has undergone the sintering step and has flux residue, using the cleaning agent composition of the present disclosure or the cleaning method according to the present disclosure (cleaning step).

In one or more embodiments, the cleaning step includes bringing the object to be cleaned having flux residue into contact with the cleaning agent composition according to the present disclosure. Examples of the cleaning method in the cleaning step include a method similar to the aforementioned cleaning method according to this disclosure. Examples of the object to be cleaned include the aforementioned objects to be cleaned.

In one or more embodiments, this disclosure further relates to the following cleaning agent composition for removing flux residue, cleaning method, and method for manufacturing a semiconductor electronic component.
<1> A cleaning agent composition for removing flux residue, containing: a compound (a component A) represented by a formula (I) below; a benzotriazole derivative (a component B); and an imidazole derivative or a pyrazole derivative (a component C),

   R¹-O-(AO)ₙ-R² (I)

   in the above formula (I), R¹ represents a phenyl group or an alkyl group having 1 to 8 carbon atoms, R² represents a hydrogen atom or an alkyl group having 1 to 4 carbon atoms, AO represents an ethylene oxide group (EO) or a propylene oxide group (PO), and n is the number of moles of AO added and is an integer of 1 to 3.
<2> The cleaning agent composition according to <1>, wherein a content of the component A is 35% by mass or more and 99.5% by mass or less.
<3> The cleaning agent composition according to <1>, wherein a content of the component A is 35% by mass or more and 99.5% by mass or less, or 50% by mass or more and 95% by mass or less, or 75% by mass or more and 90% by mass or less.
<4> The cleaning agent composition according to any one of <1> to <3>, wherein a content of the component B is 0.05% by mass or more and 5% by mass or less.
<5> The cleaning agent composition according to any one of <1> to <4>, wherein a content of the component B is 0.05% by mass or more and 5% by mass or less, or 0.1% by mass or more and 3% by mass or less, or 0.3% by mass or more and 1% by mass or less.
<6> The cleaning agent composition according to any one of <1> to <5>, wherein a mass ratio B/C of the component B to the component C is 0.01 or more and 100 or less.
<7> The cleaning agent composition according to any one of <1> to <6>, wherein a mass ratio B/C of the component B to the component C is 0.01 or more and 100 or less, or 0.1 or more and 10 or less, or 0.5 or more and 5 or less.
<8> The cleaning agent composition according to any one of <1> to <7>, wherein a mass ratio A/B of the component A to the component B (a content of the component A/a content of the component B) is 50 or more and 1000 or less, or 100 or more and 500 or less, or 150 or more and 300 or less.
<9> The cleaning agent composition according to any one of <1> to <8>, wherein a mass ratio A/C of the component A to the component C (a content of the component A/a content of the component C) is 20 or more and 500 or less, or 50 or more and 300 or less, or 70 or more and 200 or less.
<10> The cleaning agent composition according to any one of <1> to <9>, further containing water (a component D).
<11> The cleaning agent composition according to <10>, wherein a content of the component D is 15% by mass or less.
<12> The cleaning agent composition according to <10>, wherein a content of the component D is 1% by mass or more and 15% by mass or less, or 5% by mass or more and 14% by mass or less, or 8% by mass or more and 13% by mass or less.
<13> The cleaning agent composition according to any one of <1> to <12>, wherein a total content of the component A, the component B, and the component C is 50% by mass or more and 100% by mass or less, or 70% by mass or more and 95% by mass or less, or 80% by mass or more and 90% by mass or less, or 85% by mass or more and 90% by mass or less.
<14> A cleaning method including a cleaning step of cleaning an object to be cleaned having flux residue, using the cleaning agent composition according to any one of <1> to <13>.
<15> The cleaning method according to <14>, wherein the object to be cleaned having flux residue is a substrate having flux residue that has undergone a process of applying a slurry containing a flux between the substrate and a metal member or between two metal members present on the substrate, and then heating to 200°C or higher.
<16> The cleaning method according to <14> or <15>, wherein a substrate surface and/or a metal member of the object to be cleaned includes an organic coating film containing an imidazole derivative.
<17> The cleaning method according to any one of <14> to <16>, wherein a substrate surface and/or a metal member of the object to be cleaned includes an organic coating film that has come into contact with an agent containing an imidazole derivative.
<18> The cleaning method according to any one of <14> to <17>, wherein the cleaning step is a step of immersing the object to be cleaned in the cleaning agent composition for flux at 80°C or lower.
<19> The cleaning method according to any one of <14> to <18>, wherein a substrate surface and/or a metal member of the object to be cleaned contains copper.
<20> A method for manufacturing a semiconductor electronic component using the cleaning method according to any one of <14> to <19>.

### Examples

Although the present disclosure will be specifically described below using examples, the present disclosure is not limited to these examples.

### 1. Preparation of Cleaning Agent Composition (Examples 1 to 18, Comparative Examples 1 to 9)

Cleaning agent compositions of Examples 1 to 18 and Comparative Examples 1 to 9 were prepared by blending components together in a 100-mL glass beaker to have compositions described in Tables 1 and 2 and mixing the mixture under the conditions below. Numerical values of the components in the tables indicate, unless otherwise specified, the content (% by mass) in the prepared cleaning agent compositions.

### <Mixing Conditions>

Liquid temperature: 25°C
Stirrer: Magnetic stirrer (50 mm rotor)
Rotation speed: 300 rpm
Stirring time: 10 minutes

The following were used as components of the cleaning agent compositions.
(Component A)
   Diethylene glycol monobutyl ether [manufactured by Nippon Nyukazai Co., Ltd.]
   Dipropylene glycol monobutyl ether [manufactured by Nippon Nyukazai Co., Ltd.]
   Diethylene glycol monohexyl ether [manufactured by Nippon Nyukazai Co., Ltd.]
(Non-Component A)
   Benzyl alcohol [manufactured by Lanxess K.K.]
(Component B)
   Benzotriazole [manufactured by Tokyo Chemical Industry Co., Ltd.]
   5-Methylbenzotriazole [manufactured by Tokyo Chemical Industry Co., Ltd.]
   BT-LX[N,N-bis(2-ethylhexyl)(1H-benzotriazole-1-yl)methylamine, manufactured by Johoku Chemical Co., Ltd.]
(Component C)
   2-Methylimidazole [manufactured by Tokyo Chemical Industry Co., Ltd.]
   1-Methylimidazole [manufactured by Tokyo Chemical Industry Co., Ltd.]
   Imidazole [manufactured by Fujifilm Wako Pure Chemical Corporation]
   Benzimidazole [manufactured by Tokyo Chemical Industry Co., Ltd.]
   Pyrazole [manufactured by Tokyo Chemical Industry Co., Ltd.]
(Non-Component C)
   1,2,3-Triazole [manufactured by Tokyo Chemical Industry Co., Ltd.]
   Tetrazole [manufactured by Tokyo Chemical Industry Co., Ltd.]
(Component D)
   Water [pure water with 1 µS/cm or less manufactured using Pure Water System G-10DSTSET manufactured by Organo Corporation]
(Other Components)
   Dibutylaminoethanol [manufactured by Nippon Nyukazai Co., Ltd.] (Basic substance)
   Diisopropanolamine [manufactured by Nippon Nyukazai Co., Ltd.] (Basic substance)
   1-Hydroxyethylidene-1,1-diphosphonic acid [DayQuest 2010 manufactured by Italmatch Japan Ltd.] (chelating agent)
   Tin(II) 2-ethylhexanoate (stannous octoate) [manufactured by Tokyo Chemical Industry Co., Ltd.] (organic carboxylic acid metal salt)

### [2. Evaluation of Cleaning Agent Composition]

The following tests were carried out using the prepared cleaning agent compositions of the Examples 1 to 18 and Comparative Examples 1 to 9, and damage to the organic coating films, a metal corrosion prevention ability (anti-corrosion property), and flux residue removal performance were evaluated.

### [Test Substrate 1 (Evaluation of Damage to Organic Coating Film and Anti-Corrosion Property)]

A test substrate 1 used for the evaluation of damage to an organic coating film and anti-corrosion property was produced as follows.

### <Preflux Treatment for Substrate (Formation of Organic Coating Film)>

Preflux treatment (Cu-OSP treatment) was performed on the test substrate using the following process under the following conditions.

### [Test Substrate]

A tough pitch copper plate (50 mm × 20 mm) was used as a test substrate.

### [Preflux Treatment]

The preflux treatment was carried out in accordance with the procedure including processes (a) to (d) below.

### (a) Degreasing Process

The test substrate was immersed in a degreasing solution (product name: Tough Cleaner W40G, manufactured by Shikoku Kasei Holdings Corporation) at 20°C to 30°C for 30 seconds, and then the substrate was taken out therefrom and washed with water for 1 minute.

### (b) Soft Etching Process

The substrate was immersed in a soft etching solution (product name: Tough Cleaner GB-1400, sulfuric acid-hydrogen peroxide type, manufactured by Shikoku Kasei Holdings Corporation) at 30°C for 30 seconds, and then the substrate was taken out therefrom and washed with water for 1 minute.

### (c) Acid Cleaning Process

The substrate was immersed in an acid cleaning solution (5% aqueous sulfuric acid solution) at 20°C to 30°C for 30 seconds, and then the substrate was taken out therefrom and washed with water for 1 minute. Thereafter, water was removed from the substrate using an air knife.

### (d) Preflux Treatment Process

The substrate was immersed in a metal treatment agent A containing an imidazole compound (water-soluble preflux, product name: Glicoat-SMD F2(LX)PK, manufactured by Shikoku Kasei Holdings Corporation) at 40°C for 30 to 90 seconds, and then the substrate was taken out therefrom and washed with water for 1 minute. Then, water was removed from the substrate using an air knife, and the substrate was dried at 100°C for 1 minute. The test substrate 1 was produced by forming an organic coating film (OSP film) with a thickness of about 0.1 to 0.3 µm on the copper surface.

### [Test Substrate 2 (Evaluation of Cleaning Performance)]

A flux (product name: DELTALUX MB-T100 manufactured by Senju Metal Industry Co., Ltd.) was printed on a copper wiring printed circuit board (10 mm × 15 mm) to a thickness of 100 µm using a stencil mask, and 300 µm solder balls with a composition of Sn-3Ag-0.5Cu (each numerical value is in % by mass) were mounted on the flux printed area. A reflow furnace was used to perform reflow at a temperature increase rate of 2.5°C/sec and a peak temperature of 250°C for 30 seconds (oxygen concentration was 100 ppm), to produce a test substrate 2.

The test substrate 2 produced here is a model that imitates joining of metals on the substrate based on the heating temperature and holding time. The sintering conditions presumed were as follows: the heating temperature was 250°C and the heating time was 4 minutes (this heating time included the holding time at 250°C (30 seconds), the temperature increase time, and the cooling time).

### [Cleaning Test]

The cleaning test was carried out according to the following procedure.

First, an ultrasonic cleaning tank, a first rinse tank, and a second rinse tank were prepared under the following conditions.

The ultrasonic cleaning tank was set to a frequency of 40 kHz and the output of 400 W. 100 g of each cleaning agent composition was added to a 500 mL glass beaker, and then placed in the ultrasonic cleaning tank and heated to 60°C.

The first rinse tank and the second rinse tank were prepared by adding 100 g of pure water to each of two 100 mL glass beakers each containing a 50 mm rotor, placing the beakers in a warm bath, and heating them to 40°C while stirring at 100 rpm.

Then, the test substrate was held with tweezers, inserted into the ultrasonic cleaning tank, and immersed in the solution at 60°C for 5 minutes (ultrasonic cleaning, 40kHz, 400W).

Next, the test substrate was held with tweezers and inserted into the first rinse tank, and the substrate was immersed in the water at 40°C for 1 minute while stirring at a rotation speed of 100 rpm (water rinse).

In addition, the test substrate was held with tweezers and inserted into the second rinse tank, and the substrate was immersed in the water at 40°C for 1 minute while stirring at a rotation speed of 100 rpm (water rinse).

Lastly, the test substrate was dried through nitrogen purge.

### [Evaluation of Damage to Organic Coating Film]

After the above cleaning test, a contact angle of the water to the surface of the test substrate 1 was measured using a drop method. Using a contact angle meter (DMo-501 manufactured by Kyowa Interface Science Co., Ltd.), a value was read 20 seconds after the droplet was created, and a water contact angle X was calculated by means of a five-point average.

The test substrate 1 was cleaned using the same method using an aqueous sulfuric acid solution adjusted to pH 1, and a water contact angle Y on the copper plate was calculated separately.

By subtracting Y from X, a residual property of the organic coating film was evaluated. The results are shown in Tables 1 and 2. The higher the value of X-Y, the more the organic coating film remained and the more damage to the organic coating film was suppressed.

**[Table 1]**

| Table 1 | | | Examples | | | | | | | | | | | | | | | | | |
|---|---|---|---|---|---|---|---|---|---|---|---|---|---|---|---|---|---|---|---|---|
| | | | 1 | 2 | 3 | 4 | 5 | 6 | 7 | 8 | 9 | 10 | 11 | 12 | 13 | 14 | 15 | 16 | 17 | 18 |
| | Component A | Diethylene glycol monobutyl ether | 85.5 | | | 85.5 | 85.5 | 85.5 | 85.5 | 85.5 | 85.5 | 85.5 | 85.5 | 85.5 | 85.5 | 85.5 | 85.5 | 85.5 | 85.5 | 85.5 |
| | | Dipropylene glycol monobutyl ether | | 85.5 | | | | | | | | | | | | | | | | |
| | | Diethylene glycol monohexyl ether | | | 85.5 | | | | | | | | | | | | | | | |
| | Component B | Benzotriazole | 0.5 | 0.5 | 0.5 | | | 0.5 | 0.5 | 0.5 | 0.5 | 0.1 | 1.0 | 0.5 | 0.5 | 0.5 | 0.5 | 0.5 | 0.5 | 0.5 |
| | | 5-Methylbenzotriazole | | | | 0.5 | | | | | | | | | | | | | | |
| | | *BT-LX | | | | | 0.5 | | | | | | | | | | | | | |
| | Component C | 2-Methylimidazole | 1.0 | 1.0 | 1.0 | 1.0 | 1.0 | | | | | 1.0 | 1.0 | 0.1 | 1.0 | 1.0 | 1.0 | 1.0 | 1.0 | 1.0 |
| Cleaning agent composition | | 1-Methylimidazole | | | | | | 1.0 | | | | | | | | | | | | |
| | | Imidazole | | | | | | | 1.0 | | | | | | | | | | | |
| | | Benzimidazole | | | | | | | | 1.0 | | | | | | | | | | |
| | | Pyrazole | | | | | | | | | 1.0 | | | | | | | | | |
| | Component D | Water | 13.0 | 13.0 | 13.0 | 13.0 | 13.0 | 13.0 | 13.0 | 13.0 | 13.0 | 13.4 | 12.5 | 13.9 | 10.5 | 8.0 | 12.9 | 7.9 | 12.9 | 12.0 |
| | Others | Dibutylaminoethanol | | | | | | | | | | | | | 2.0 | 4.0 | | 4.0 | | |
| | | Diisopropanolamine | | | | | | | | | | | | | 0.5 | 1.0 | | 1.0 | | |
| | | 1-Hydroxyethylidene-1,1-diphosphonic acid | | | | | | | | | | | | | | | 0.1 | 0.1 | | |
| | | Stannous octoate | | | | | | | | | | | | | | | | | 0.1 | 1.0 |
| | Mass ratio [Component B/component C] | | 0.5 | 0.5 | 0.5 | 0.5 | 0.5 | 0.5 | 0.5 | 0.5 | 0.5 | 0.1 | 1.0 | 5.0 | 0.5 | 0.5 | 0.5 | 0.5 | 0.5 | 0.5 |
| | Damage to organic coating film | X-Y | 14 | 13 | 14 | 11 | 15 | 10 | 13 | 12 | 13 | 10 | 15 | 10 | 14 | 14 | 14 | 16 | 12 | 10 |
| | | X: water contact angle after cleaning | | | | | | | | | | | | | | | | | | |
| Evaluation | | Y: water contact angle after acid treatment | | | | | | | | | | | | | | | | | | |
| | Anti-corrosion property | Discoloration suppression | A | A | A | A | A | A | A | B | A | B | A | B | A | A | A | A | A | B |

| | | | | | | | | | | | | | | | | | | | | |
|---|---|---|---|---|---|---|---|---|---|---|---|---|---|---|---|---|---|---|---|---|
| *BT-LX: N,N-bis(2-ethylhexyl)(1H-benzotriazole-1-yl)methylamine | | | | | | | | | | | | | | | | | | | | |

**[Table 2]**

| Table 2 | | | Comparative Examples | | | | | | | | |
|---|---|---|---|---|---|---|---|---|---|---|---|
| | | | 1 | 2 | 3 | 4 | 5 | 6 | 7 | 8 | 9 |
| | Component A | Diethylene glycol monobutyl ether | | | 85.5 | 85.5 | 85.5 | 85.5 | 85.5 | 85.5 | 85.5 |
| | Non-Component A | Benzyl alcohol | 85.5 | 85.5 | | | | | | | |
| | Component B | Benzotriazole | 0.5 | 0.5 | | | 0.5 | 0.5 | 0.5 | 0.5 | 0.5 |
| | Component C | Benzimidazole | | | | 0.5 | | | | | |
| Cleaning agent composition | | 2-Methylimidazole | 1.0 | | 1.0 | 1.0 | | | | | |
| | | 1-Methylimidazole | | 1.0 | | | | | | | |
| | Non-Component C | 1,2,3-Triazole | | | | | | 1.0 | | | |
| | | Tetrazole | | | | | | | 1.0 | | |
| | Component D | Water | 13.0 | 13.0 | 13.5 | 13.0 | 14.0 | 13.0 | 13.0 | 13.9 | 13.0 |
| | Others | Stannous octoate | | | | | | | | 0.1 | 1.0 |
| | Mass ratio [Component B/Component C] | | 0.5 | 0.5 | 0.0 | 0.5 | - | 0.5 | 0.5 | - | - |
| Evaluation | Damage to organic coating film | X-Y | 0 | 1 | 0 | 1 | 1 | 2 | 2 | 1 | 0 |
| | | X: water contact angle after cleaning | | | | | | | | | |
| | | Y: water contact angle after acid treatment | | | | | | | | | |
| | Anti-corrosion property | Discoloration suppression | D | D | D | D | D | D | D | D | D |

As shown in Tables 1 and 2 above, with the cleaning agent compositions of Examples 1 to 18, damage to the organic coating film was further suppressed, compared to Comparative Examples 1 to 9.

### [Evaluation of Anti-Corrosion Property]

After the evaluation of the organic coating films, the test substrate 1 was observed using an optical microscope (VHX-2000 manufactured by Keyence Corporation). The test substrate 1 was placed in a thermo-hygrostat (PR-1J manufactured by ESPEC CORP.) and left to stand for 24 hours under conditions of a temperature of 85°C and a relative humidity of 85% rh, after which the test substrate 1 was taken out. The test substrate 1 was visually observed with the optical microscope VHX-2000, and the appearances of the substrate before and after storage under constant temperature and constant humidity conditions were compared, and the anti-corrosion property was evaluated according to the following criteria. The results are shown in Tables 1 and 2.

### <Criteria>

A: Neither color unevenness nor discoloration was observed.
B: No color unevenness was observed, but discoloration was observed.
C: Discoloration was observed, and a portion was browned.
D: The entire test substrate was browned.

The cleaning agent composition of Example 1 containing the component B and the component C was superior in suppressing the discoloration of copper (anti-corrosion property) compared to Comparative Examples 3 and 5 that did not contain the component B or the component C (Example 1: A, Comparative Examples 3 and 5: D). The cleaning agent compositions, which had a large X-Y value in the evaluation of the water contact angle after cleaning and retained organic coating films, had an excellent anti-corrosion property, and Examples 2 to 18 also had an excellent anti-corrosion property.

### [Evaluation of Cleaning Performance (Flux Residue Removal Performance)]

After the above cleaning test, the test substrate 2 was observed with an optical microscope (VHX-2000 manufactured by Keyence Corporation), and the area of flux residue before and after cleaning was calculated by using the area calculation mode through included color identification, to calculate a flux residue cleaning percentage.

The cleaning agent composition of Example 1, which contained the component A, had a flux residue cleaning percentage of 100% (complete cleaning), and had excellent flux residue removal performance. Examples 2 to 18 containing the component A also had excellent flux residue removal performance.

### Industrial Applicability

Use of the cleaning agent composition according to this disclosure can efficiently remove flux residue while suppressing metal corrosion and damage to the organic coating film. Therefore, for example, it is possible to shorten the flux cleaning step in the process of manufacturing a semiconductor device and improve the performance and reliability of the manufactured semiconductor device, thereby improving the productivity of the semiconductor device.

## Claims

1. A cleaning agent composition for removing flux residue, comprising:
a compound (a component A) represented by a formula (I) below;
a benzotriazole derivative (a component B); and
an imidazole derivative or a pyrazole derivative (a component C),
R¹-O-(AO)ₙ-R² (I)
in the above formula (I), R¹ represents a phenyl group or an alkyl group having 1 to 8 carbon atoms, R² represents a hydrogen atom or an alkyl group having 1 to 4 carbon atoms, AO represents an ethylene oxide group (EO) or a propylene oxide group (PO), and n is the number of moles of AO added and is an integer of 1 to 3.

2. The cleaning agent composition according to claim 1,
wherein a content of the component A is 35% by mass or more and 99.5% by mass or less.

3. The cleaning agent composition according to claim 1 or 2,
wherein a content of the component B is 0.05% by mass or more and 5% by mass or less.

4. The cleaning agent composition according to any one of claims 1 to 3,
wherein a mass ratio B/C of the component B to the component Cis 0.01 or more and 100 or less.

5. The cleaning agent composition according to any one of claims 1 to 4,
wherein a mass ratio B/C of the component B to the component Cis 0.01 or more and 10 or less.

6. The cleaning agent composition according to any one of claims 1 to 5, further comprising
water (a component D).

7. The cleaning agent composition according to claim 6,
wherein a content of the component D is 15% by mass or less.

8. A cleaning method comprising
a cleaning step of cleaning an object to be cleaned having flux residue, using the cleaning agent composition according to any one of claims 1 to 7.

9. The cleaning method according to claim 8,
wherein the object to be cleaned having flux residue is a substrate having flux residue that has undergone a process of applying a slurry containing a flux between the substrate and a metal member or between two metal members present on the substrate, and then heating to 200°C or higher.

10. The cleaning method according to claim 8 or 9,
wherein a substrate surface and/or a metal member of the object to be cleaned includes an organic coating film containing an imidazole derivative.

11. The cleaning method according to any one of claims 8 to 10,
wherein a substrate surface and/or a metal member of the object to be cleaned includes an organic coating film that has come into contact with an agent containing an imidazole derivative.

12. The cleaning method according to any one of claims 8 to 11,
wherein the cleaning step is a step of immersing the object to be cleaned in the cleaning agent composition for removing flux residue at 80°C or lower.

13. The cleaning method according to any one of claims 8 to 12,
wherein a substrate surface and/or a metal member of the object to be cleaned contains copper.

14. A method for manufacturing an electronic component using the cleaning method according to any one of claims 8 to 13.
